(19) Europäisches Patentamt
European Patent Office
Office européen des brevets

(11) EP 0 424 638 B1

(12) **EUROPEAN PATENT SPECIFICATION**

(45) Date of publication and mention of the grant of the patent:
**11.02.1998 Bulletin 1998/07**

(51) Int Cl.[6]: **H01L 21/312**, H01L 21/316

(21) Application number: **90116599.3**

(22) Date of filing: **29.08.1990**

(54) **Fabrication of a semiconductor device including a step of providing a layer of insulating material formed from an organo-silica sol**

Herstellung einer Halbleitereinrichtung eine Stufe zum Erzeugen einer aus Organokiesel-Sol isolierenden Schicht enthaltend

Fabrication d'un composant semi-conducteur comprenant une étape de formation d'un film isolant à base d'un organo-sol silicique

(84) Designated Contracting States:
**FR**

(30) Priority: **31.08.1989 JP 225237/89**

(43) Date of publication of application:
**02.05.1991 Bulletin 1991/18**

(73) Proprietors:
- **FUJITSU LIMITED**
**Kawasaki-shi, Kanagawa 211 (JP)**
- **KYUSHU FUJITSU ELECTRONICS LIMITED**
**Kagoshima, 895-14 (JP)**

(72) Inventor: **Harada, Hideki**
**Kawasaki-shi, Kanagawa 211 (JP)**

(74) Representative:
**Schmidt-Evers, Jürgen, Dipl.-Ing. et al**
**Patentanwälte**
**Mitscherlich & Partner,**
**Postfach 33 06 09**
**80066 München (DE)**

(56) References cited:

| | |
|---|---|
| **EP-A- 0 076 656** | **EP-A- 0 223 987** |
| **EP-A- 0 226 208** | **EP-A- 0 313 095** |
| **DE-A- 3 537 626** | **US-A- 4 615 782** |
| **US-A- 4 798 629** | **US-A- 4 900 582** |

- **IBM TECHNICAL DISCLOSURE BULLETIN, vol. 28, no. 12, May 1986, page 5246, New York, US; Anonymous disclosure: "Polysiloxane dielectric for multi-level metal"**
- **PATENT ABSTRACTS OF JAPAN, vol. 13, no. 49 (C-565)[3397], 3rd February 1989; & JP-A-63 243 174 (SUMITOMO CHEM. CO., LTD) 11-10-1988**
- **PATENT ABSTRACTS OF JAPAN, vol. 12, no. 106 (E-596)[2953], 6th April 1988; & JP-A-62 235 738 (MATSUSHITA ELECTRIC) 15-10-1987**
- **THIN SOLID FILMS, vol. 157, no. 1, 15th February 1988, pages 129-134, Elsevier Sequoia, Lausanne, CH; M. KUISL: "Silicon dioxide films prepared by spin-on solutions"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 424 638 B1

## Description

### BACKGROUND OF THE INVENTION

The present invention generally relates to fabrication of semiconductor devices and more particularly to a process for producing an insulating material for use in a semiconductor device as an inter-layer insulation, a surface protection film, and the like.

There are two distinct type of insulating materials used in semiconductor devices, one used for capacitors or gate insulator films which is required to have a maximum dielectric constant and a high breakdown voltage, and the other used for inter-layer insulation or surface protection wherein properties such as a minimum dielectric constant, minimum leak current, excellent step coverage are required. In the former type insulating material, it is important to achieve a large capacitance in a minimum area, while in the latter type insulating material, it is essential to minimize the parasitic capacitance formed by the material so that the operational speed of the semiconductor device is improved.

Conventionally, glasses containing boron or phosphorus such as phosphosilicate glasses (PSG), borosilicate glasses (BSG), phospho-borosilicate glasses (PBSG), and the like, are used in the semiconductor devices for inter-layer insulation and surface protection. In addition to these materials, there is a material commonly called spin-on-glass (SOG) which is a silicon oxide glass obtained, for example, by hydrolysis and polycondensation of alkoxysilane compounds. This material is usually applied on the semiconductor device in a form of liquid, and is particularly useful for obtaining a planarized insulation structure.

However, conventional SOG has a problem in that the parasitic capacitance is relatively large because of the relatively large specific dielectric constant which is usually larger than about four. Further, the conventional SOG generally has a porous texture which tends to invite increase in the leak current. Furthermore, there is a tendency that SOG is cracked at the time of heat-treatment during the fabrication process of the semiconductor device.

Although the use of organic polymers such as polyimides for such an inter-layer insulation or surface protection is studied, these organic polymers are generally immune to the etching process used commonly in the conventional fabrication process.

From document EP-A-0 313 095 a method of forming a silicon dioxide film is known, wherein a silicon compound having the formula $R^1Si(OR^2)_3$, with $R^1$ and $R^2$ both being alkyls, is hydrolysed. The resultant liquid is applied to a silicon wafer and heat is used to form the silicon oxide film.

Document EP-A-0 226 208 discloses the use of a mixture of three different alkoxysilanes, wherein a tetraalkoxysilane, an alkyl-trialkoxysilane and a dialkyl-dialkoxysilane are mixed and hydrolysed in the presence of water, wherein the molar ratios A, B, C of the three alkoxysilanes fall within the relation $(B+2C)/(A+B+C) \geqq 0.75$. A semiconductor is then coated with the solution and heat is used to form a silicon oxide film. Similarly, document US-A-4 798 629 shows the use of a mixture of three specific alkoxysilanes to form a silicon oxide film.

### SUMMARY OF THE INVENTION

It is an object of the present invention to provide a novel and useful process for producing an insulating material wherein the foregoing problems are eliminated.

Another and more specific object of the present invention is to provide a process for producing an insulating material suitable for inter-layer insulation or surface protection of semiconductor devices, wherein the produced insulating material is characterized by a reduced dielectric constant, reduced leak current, and improved step coverage.

These objects are achieved by a method of fabricating a semiconductor device according to claim 1.

According to the present invention, the proportion of the radical $R^1$ in the insulating material is increased, and thereby the radicals $R_1$ are bonded to the silicon atoms which are not fully cross-linked with other silicon atoms. As a result, the proportion of the OH ions which may be bonded to the silicon atoms is decreased, and associated therewith, the undesirable increase of the dielectric constant, which is caused mainly by the absorption of the water vapor in the atmosphere by the insulating material, is effectively prevented. Because of the reduced absorption of the water vapor, the material thus obtained shows a hydrophobic property. When the insulating material of the present invention is applied to the insulation layer of the multi-level interconnection structure of semiconductor devices, the operational speed of the semiconductor device is improved due to the reduced parasitic capacitance. Further, a preferable feature such as the decrease in the leak current through the insulating material is obtained.

Other objects and further features of the present invention will become apparent from the following detailed description when read in conjunction with the attached drawings.

### BRIEF DESCRIPTION OF THE DRAWINGS

FIG.1 is a graph showing the effect achieved by the present invention;

FIG.2 is a schematical diagram showing the structure of the insulating material obtained according to the process of the present invention; and

FIG.3 is a cross sectional view showing a multi-level interconnection structure of a semiconductor device wherein the insulating material of the present invention is used.

## DETAILED DESCRIPTION

Before starting the description of the process of the present invention, a typical conventional process for producing the SOG will be described.

## PRIOR ART PROCESS

According to this conventional process, 100 grams of tetramethoxysilane and 100 grams of methyltrimethoxysilane are mixed in a flask. While mixing in the flask, 130 grams of de-ionized water is added to cause a hydrolysis reaction of the alkoxy groups included in the tetramethoxysilane and the methyltrimethoxysilane. After the hydrolysis, the mixture is held at a temperature of about 50°C for about 2 hours so that there occurs a polycondensation reaction of silanol compounds forming an organo-silica sol polymer compound which has the weight-average molecular weight of 2 - 5 X $10^3$. The polymer thus formed is further characterized by the ratio of the weight-average molecular weight divided by the number-average molecular weight of about 2.5. After heat-treating the silica sol thus obtained at a temperature of about 450°C, silicon oxide is obtained as the insulating material. The insulating material thus obtained typically has the specific dielectric constant of about 5.

Next, the process according to the present invention will be described with respect to the embodiments.

## FIRST EMBODIMENT

According to the first embodiment, 30 grams of tetramethoxysilane and 100 grams of methyltrimethoxysilane are mixed in a flask with a mole ratio of about 1 : 3.7. While mixing in the flask, 130 grams of de-ionized water is added to cause a hydrolysis reaction of the alkoxy groups included in the tetramethoxysilane and the methyltrimethoxysilane. After the hydrolysis, the mixture is held at about 50°C for about 2 hours so that there occurs a polycondensation reaction of silanol groups to form an organo-silica sol polymer compound. The obtained polymer compound has the weight-average molecular weight of 3 - 6 X $10^3$. The polymer thus formed is further characterized by the ratio of the weight-average molecular weight divided by the number-average molecular weight of about 2.5. After heat-treating the silica sol thus obtained at a temperature of about 450 °C, silicon oxide is obtained as the insulating material. The insulating material thus obtained typically has the specific dielectric constant of about 3.4 which value is significantly lower than that for the conventional material.

## SECOND EMBODIMENT

According to the present embodiment, 100 grams of tetramethoxysilane and 130 grams of dimethyldimethoxysilane are mixed in a flask with a mole ratio of 2 : 3.8. While mixing, 180 grams of de-ionized water is added to cause a hydrolysis reaction of the alkoxy groups included in the tetramethoxysilane and the dimethyldimethoxysilane. After the hydrolysis, the mixture is held at about 50°C for about 2 hours, so that there occurs a polycondensation reaction of silanol groups to form an organo-silica sol polymer compound. The polymer compound thus obtained has the weight-average molecular weight of 2 - 5 X $10^3$. The polymer thus formed is further characterized by the ratio of the weight average molecular weight divided by the number-average molecular weight of about 2.5. After heat-treating the silica sol thus obtained at a temperature of about 450°C, silicon oxide is obtained as the insulating material. The insulating material thus obtained typically has the specific dielectric constant of about 3.5 which value is significantly lower than that for the conventional material.

## THIRD EMBODIMENT

In this embodiment, 130 grams of de-ionized water is added to 100 grams of methyltrimethoxysilane while stirring in a flask. Thereby, the alkoxyl groups in the methyltrimethoxysilane are subjected to the hydrolysis reaction, and after holding at 50°C for about 2 hours for the polymerization reaction of silanol groups, a product organo-silica sol polymer compound having the weight-average molecular weight of 1 - 3 X $10^3$ and characterized by the ratio of the weight-average molecular weight divided by the number-average molecular weight of about 2 is obtained. After heat-treating the product silica sol at a temperature of about 450°C, silicon oxide having the specific dielectric constant of about 2.9 is obtained as the insulating material.

Further, experiments were conducted to form silicon oxide from a silica sol produced from a mixture of metyltrialkoxysilanes referred to hereinafter as compound T and tetraalkoxysilanes referred to hereinafter as compound Q while variously changing the ratio of T to Q.

The reaction to produce the silica sol is represented as

l : m : n

Trifunctional (T group) Tetrafunctional (Q group)

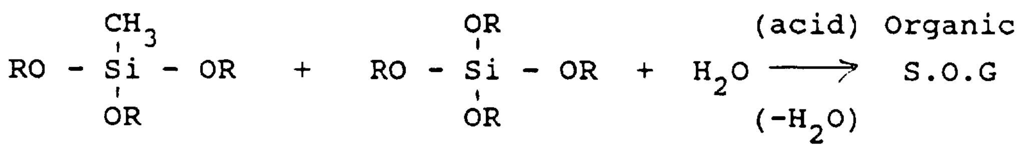


wherein the weight-average molecular weight of the organo-silica sol is adjusted to be 3 X $10^3$.

FIG.1 shows the result of the measurement of the specific dielectric constant of the silicon oxide film formed from the organo-silica sol thus obtained for various mixing ratios (l : m).

In FIG.1, the solid circles represent the case where $CH_3$ is used for the atomic group R. In other words, the compound $CH_3Si(OR)_3$ for this case is methylmethoxysilane, and the compound $Si(OR)_4$ for this case is tetramethoxysilane. It should be noted that the ratio of 3/4 in the abscissa corresponds to the case where the T compound and the Q compound are mixed with a ratio of 3 : 1. In other words, the solid circle at the ratio of 3/4 on the abscissa represents the first embodiment of the present invention. Further, the solid circle at the ratio of 1/2 represents the conventional case explained previously. In FIG.1, the result of measurement for another composition in which the proportion of the Q compound is increased with respect to the T component (T/Q ratio = 1/4) is also shown. The preparation of this compound is made similarly to the compounds of the T/Q ratio of 1/2 or 3/4, and the description thereof will be omitted.

As clearly shown, it was found that there is a definite tendency that the specific dielectric constant of the silicon oxide obtained form the organo-silica sol decreases with increasing proportion of the T compound when mixing the T compound and the Q compound. By using the T/Q ratio of 3/4, one can obtain the specific dielectric constant of about 3.4 as already described.

Further, FIG.1 shows the result of the specific dielectric constant measurement for other compounds wherein $C_2H_5$ or $C_4H_9$ are used as the atomic group R. In FIG.1, the case wherein $C_2H_5$ is used for the atomic group R is represented by the solid triangles, and the case wherein $C_4H_9$ is used for the atomic group R is represented by the solid squares. Again, the tendency of decreasing specific dielectric constant with increasing T/Q ration is clearly observed. This means that the present invention described heretofore with reference to the first through fourth embodiments is by no means limited to the mixing of methyltrimethoxysilane as the compound T and tetramethoxysilane as the compound Q, but is applicable also to the general case where metyltrialkoxysilanes are mixed with tetraalkoxysilanes. Further, the compound T is not limited to methyltrialkoxysilanes but other silicon compounds having a general formula of $R^1Si(OR^2)_4$ with the number of carbon atoms of 1 - 6, may be employed as in the case of the second embodiment.

FIG.2 shows a schematical view of the structure of silicon oxide obtained in accordance with any of the foregoing processes. As can be seen, there is a network of cross-linked silicon bonded by sharing an oxygen atom as is common in such a structure. The significance of the present invention resides in the fact that any silicon atom having a bond that has failed to cross-link with other silicon atom is bonded more or less with the atomic group $R^1$. Thereby, the proportion of the bond of silicon which is not bonded with any other atoms or radicals is substantially eliminated, and the absorption of water caused mainly by the attraction of OH radicals to such a free bond is effectively suppressed. In other words, the silicon oxide thus obtained shows the hydrophobic property. It is believed that this is the reason why the specific dielectric constant of the silicon oxide is decreased according to the process of the present invention.

Next, a fifth embodiment of the present invention for applying the process of the present invention for the fabrication of semiconductor devices will be described.

In this embodiment, the organo-silica sol polymer obtained in the process of any of the foregoing embodiments is added with a commonly used hydrophilic organic solvent such as propyleneglycolmonopropyletherethyll lactate with a proportion of 80 percent by weight. Thereby, an organic solution of the organo-silica sol for application to the fabrication process is obtained. It should be noted that, when the amount of the organic solvent is smaller than about 80 percent by weight, the viscosity of the organic solution becomes excessively high and use of the organic solution for the fabrication of semiconductor devices by the process such as spin-coating becomes difficult.

Referring to FIG.3, the organic solution is applied on a semiconductor substrate 1 on which a first layer interconnection 2 is already provided, by using the spin coating process. After the application of the organic solution, the substrate is held at a temperature of 120°C for about 10 minutes to evaporate the solvent, and heat-treated afterwards at a temperature of 450°C for about 30 minutes to form a solid silicon oxide layer 3 with a thickness of 5000 Å. Further, a PSG layer 4 is deposited with a thickness of about 5000 Å, and contact holes not illustrated are provided through the layers 3 and 4 to expose the interconnection 2. Further, a second layer interconnection 5 is provided on the PSG layer 4, and a silicon oxide layer 6 and a PSG layer 7 are formed similarly to the case of the layers 3 and 4. Furthermore, a third layer interconnection 8 is provided and the interconnection 8 is covered by a surface protection film 9 which comprises the silicon oxide formed similarly to the layers 3 and 6. This surface protection film 9 may be a PSG film similar to the layers 4 and 7.

The interconnections 2, 5 and 7 are provided such that the semiconductor device thus fabricated operates as an eight-stage ring oscillator. In order to confirm the effect of the dielectric constant on the performance of the semiconductor device, the semiconductor device samples are fabricated by using the various compositions of the mixture, and the signal delay time for each of the samples were measured.

The following Table I summarizes the relationship between the specific dielectric constant of the silicon oxide layers 3 and 6 and the observed signal delay time. As can be seen, the signal delay time is decreased when the silicon oxide layer having the reduced dielectric constant is employed.

TABLE I

| specific dielectric constant | signal delay time (picoseconds) |
|---|---|
| 9.1 | 458 |
| 4.6 | 377 |
| 3.0 | 348 |

**Claims**

**1.** A method of fabricating a semiconductor device including a step of providing a layer of an insulating material on a substrate of the semiconductor device, said method comprising the steps of:

causing a hydrolysis of a silicon compound having a formula $R^1Si(OR^2)_3$, where $R^1$ stands for an alkyl or allyl containing 1-6 carbon atoms, $R^2$ stands for an alkyl containing 1-6 carbon atoms so that an organo-silica sol having a weight-average molecular weight of $10^3$-$10^5$ is formed by a polycondensation;
dispersing the organo-silica sol in a hydrophilic organic solvent to form a liquid of the organo-silica sol, wherein the amount of the hydrophilic organic solvent in the organo-silica sol is at least 80% by weight;
applying the liquid of the organo-silica sol on the substrate of the semiconductor device; removing the organic solvent; and
applying a heat treatment to the organo-silica sol to form a solidified silicon oxide.

**2.** A method according to claim 1,
**characterized in that**
said silicon compound consists of methyltrimethoxysilane.

**3.** A method according to claim 1,
**characterized in that**

prior to said step of causing a hydrolysis a step of mixing a further silicon compound having a formula $Si(OR^2)_4$, where $R^2$ stands for an alkyl containing 1-6 carbon atoms, with said silicon compound having the formula $R^1Si(OR^2)_3$ and water is carried out;
wherein, in the step of mixing, the silicon compound having the formula $R^1Si(OR^2)_3$ is mixed with a ratio of 3 or more in moles with respect to 1 mole of the further silicon compound having the formula $Si(OR^2)_4$, and the water is added with an amount substantially equal by weight to a total amount of the both silicon compounds; the hydrolysis then being carried out on said mixture.

**4.** A method according to claim 3,
**characterized in that**
said further silicon compound having the formula $Si(OR^2)_4$ is a tetraalkoxysilane and said silicon compound having the formula $R^1Si(OR^2)_3$ is a methyltrialkoxysilane.

**5.** A method according to claim 4,
**characterized in that**
said further silicon compound having the formula $Si(OR^2)_4$ consists of tetramethoxysilane and said silicon compound having the formula $R^1Si(OR^2)_3$ consists of methyltrimethoxysilane.

**6.** A method of fabricating a semiconductor device including a step of providing a layer of an insulating material on a substrate of the semiconductor device, said method comprising the steps of: forming a mixture of a

silicon compound having a formula $R^1_2Si(OR^2)_2$ and
a further silicon compound having a formula $Si(OR^2)_4$, where $R^1$ stands for an alkyl or allyl containing 1-6 carbon atoms and $R^2$ stands for an alkyl containing 1-6 carbon atoms, and water;
wherein, in the step of mixing, the silicon compound having the formula $R^1_2Si(OR^2)_2$ is mixed with a ratio of 3 or more in moles with respect to 2 moles of the further silicon compound having the formula $Si(OR^2)_4$, and the water is added with an amount substantially equal by weight to a total amount of the both silicon compounds;
causing a hydrolysis of said mixture so that an organo-silica sol having a weight-average molecular weight of $10^3$-$10^5$ is formed by a polycondensation;
dispersing the organo-silica sol in a hydrophilic organic solvent to form a liquid of the organo-silica sol, wherein the amount of the hydrophilic organic solvent in the organo-silica sol is at least 80% by weight;
applying the liquid of the organo-silica sol on the substrate of the semiconductor device; removing the organic solvent; and
applying a heat treatment to the organo-silica sol to form a solidified silicon oxide.

**7.** A method according to claim 6,
**characterized in that**
said further silicon compound having the formula $Si(OR^2)_4$ consists of tetramethoxysilane and said silicon compound having the formula $R^1Si(OR^2)_2$ consists of dimethyldimethoxysilane.

## Patentansprüche

**1.** Verfahren zur Herstellung einer Halbleiteranordnung mit einem Schritt Ausbilden einer Schicht aus einem isolierenden Material auf einem Substrat der Halbleiteranordnung, wobei das Verfahren die Schritte umfaßt:

Herbeiführen einer Hydrolyse einer der Formel $R^1Si(OR^2)_3$ entsprechenden Siliziumverbindung, wobei $R^1$ ein Alkyl oder Allyl mit 1-6 Kohlenstoffatomen und $R^2$ ein Alkyl mit 1-6 Kohlenstoffatomen bezeichnet, so daß durch Polykondensation ein Organosilikasol mit einem durchschnittlichen Molekulargewicht von $10^3$-$10^5$ gebildet wird, Auflösen des Organosilikasols in einem hydrophilen organischen Lösungsmittel, um eine Flüssigkeit des Organosilikasols herzustellen, wobei der Anteil des hydrophilen organischen Lösungsmittels in dem Organosilikasol mindestens 80 Gewichtsprozent beträgt,
Auftragen der Flüssigkeit des Organosilikasols auf das Substrat der Halbleiteranordnung, Entfernen des organischen Lösungsmittels, und
Anwenden einer Wärmebehandlung auf das Organosilikasol, um ein verfestigtes Siliziumoxid zu bilden.

**2.** Verfahren nach Anspruch 1,
**dadurch gekennzeichnet,**
daß die Siliziumverbindung aus Methyltrimethoxysilan besteht.

**3.** Verfahren nach Anspruch 1,
**dadurch gekennzeichnet,**

daß vor dem Schritt Durchführen einer Hydrolyse ein Schritt Mischen einer der Formel $Si(OR^2)_4$ entsprechenden weiteren Siliziumverbindung, wobei $R^2$ ein Alkyl mit 1-6 Kohlenstoffatomen bezeichnet, mit der der Formel $R^1Si(OR^2)_3$ entsprechenden Siliziumverbindung und Wasser durchgeführt wird,
wobei in dem Mischschritt die der Formel $R^1Si(OR^2)_3$ entsprechende Siliziumverbindung mit einem Verhältnis von mindestens 3 mol auf 1 mol der der Formel $Si(OR^2)_4$ entsprechenden weiteren Siliziumverbindung gemischt und das Wasser mit einem Gewichtsanteil hinzugefügt wird, der im wesentlichen dem Gesamtgewicht der beiden Siliziumverbindungen entspricht, und wobei die Hydrolyse anschließend mit dieser Mischung durchgeführt wird.

4. Verfahren nach Anspruch 3,
**dadurch gekennzeichnet,**
daß die der Formel $Si(OR^2)_4$ entsprechende weitere Siliziumverbindung ein Tatraalkoxysilan und die der Formel $R^1Si(OR^2)_3$ entsprechende Siliziumverbindung ein Methyltrialkoxysilan ist.

5. Verfahren nach Anspruch 4,
**dadurch gekennzeichnet,**
daß die der Formel $Si(OR^2)_4$ entsprechende weitere Siliziumverbindung aus Tetramethoxysilan und die der Formel $R^1Si(OR^2)_3$ entsprechende Siliziumverbindung aus Methyltrimethoxysilan besteht.

6. Verfahren zur Herstellung einer Halbleiteranordnung mit einem Schritt Ausbilden einer Schicht aus einem isolierenden Material auf einem Substrat der Halbleiteranordnung, wobei das Verfahren die Schritte umfaßt:

   Bilden einer Mischung aus einer der Formel $R^1{}_2Si(OR^2)_2$ entsprechenden Siliziumverbindung mit einer der Formel $Si(OR^2)_4$ entsprechenden weiteren Siliziumverbindung und Wasser, wobei $R^1$ ein Alkyl oder Allyl mit 1-6 Kohlenstoffatomen und $R^2$ ein Alkyl mit 1-6 Kohlenstoffatomen bezeichnet,
   wobei in dem Mischschritt die der Formel $R^1{}_2Si(OR^2)_2$ entsprechende Siliziumverbindung mit einem Verhältnis von mindestens 3 mol auf 2 mol der der Formel $Si(OR^2)_4$ entsprechenden weiteren Siliziumverbindung gemischt und das Wasser mit einem Gewichtsanteil hinzugefügt wird, der im wesentlichen dem Gesamtgewicht der beiden Siliziumverbindungen entspricht,
   Herbeiführen einer Hydrolyse dieser Mischung, so daß durch Polykondensation ein Organosilikasol mit einem durchschnittlichen Molekulargewicht von $10^3$-$10^5$ gebildet wird, Auflösen des Organosilikasols in einem hydrophilen organischen Lösungsmittel, um eine Flüssigkeit des Organosilikasols herzustellen, wobei der Anteil des hydrophilen organischen Lösungsmittels in dem Organosilikasol mindestens 80 Gewichtsprozent beträgt,
   Auftragen der Flüssigkeit des Organosilikasols auf das Substrat der Halbleiteranordnung, Entfernen des organischen Lösungsmittels, und
   Anwenden einer Wärmebehandlung auf das Organosilikasol, um ein verfestigtes Siliziumoxid zu bilden.

7. Verfahren nach Anspruch 6,
**dadurch gekennzeichnet,**
daß die der Formel $Si(OR^2)_4$ entsprechende weitere Siliziumverbindung aus Tetramethoxysilan und die der Formel $R^1Si(OR^2)_2$ entsprechende Siliziumverbindung aus Dimethyldimethoxysilan besteht.

## Revendications

1. Procédé de fabrication d'un composant semiconducteur comprenant une étape de formation d'une couche d'un matériau isolant sur un substrat de composant semi-conducteur, ledit procédé comprenant les étapes de :

   réalisation d'une hydrolyse d'un composant de silicium ayant une formule $R^1Si(OR^2)_3$, où $R^1$ représente un alkyle ou un allyle contenant 1 à 6 atomes de carbone, $R^2$ représente un alkyle comprenant 1 à 6 atomes de carbone de sorte qu'un sol organo silicique ayant un poids moléculaire de poids moyen de $10^3$ à $10^5$ est formé par polycondensation ;
   dispersion du sol organo silicique dans un solvant organique hydrophilique pour former un liquide de sol organo silicique, où la quantité de solvant organique hydrophilique dans le sol organo silicique est inférieur à 80 % en poids ;
   application du liquide sol organo silicique sur le substrat du composant semi-conducteur, enlèvement du solvant ; et
   application d'un traitement thermique au sol organo silicique pour former un oxyde de silicium solidifié.

2. Procédé selon la revendication 1, caractérisé en ce que
   ledit composé de silicium se compose de méthyltriméthoxysilane.

3. Procédé selon la revendication 1, caractérisé en ce que

   avant ladite étape de réalisation d'une hydrolyse, une étape de mélange d'un autre composé de silicium ayant une formule $Si(OR^2)_4$, où $R^2$ représente un alkyle contenant 1 à 6 atomes de carbone, avec ledit composé de silicium ayant la formule $R^1Si(OR^2)_3$ et l'eau est réalisé ;

où dans l'étape de mélange, le composé de silicium ayant la formule $R^1Si(OR^2)_3$ est mélangé avec un rapport de 3 ou plus en moles par rapport à 1 mole de l'autre composé de silicium ayant la formule $Si(OR^2)_4$, et l'eau est ajoutée avec une quantité substantiellement égale en poids d'une quantité totale des deux composés de silicium ;
une hydrolyse étant alors réalisé sur ledit mélange.

**4.** Procédé selon la revendication 3, caractérisé en ce que
ledit autre composé de silicium ayant la formule $Si(OR^2)_4$ est un tétraalkoxysilane et ledit composé de silicium ayant la formule $R^1Si(OR^2)_3$ est un méthyltrialkoxysilane.

**5.** Procédé selon la revendication 4, caractérisé en ce que
ledit autre composé de silicium ayant la formule $Si(OR^2)_4$ se compose de tétraméthoxysilane et ledit composé de silicium ayant la formule $R^1Si(OR^2)_3$ se compose de méthyltriméthoxysilane.

**6.** Procédé de fabrication d'un composant semiconducteur comprenant une étape de formation d'une couche de matériau isolant sur un substrat du composant semi-conducteur, ledit procédé comprenant les étapes de :

formation d'un mélange d'un composé de silicium ayant la formule $R_2{}^1Si(OR^2)_2$ et
un autre composé de silicium ayant une formule $Si(OR^2)_4$, où $R^2$ représente un alkyle ou un allyle contenant 1 à 6 atomes de carbone et $R^2$ représente un alkyle contenant 1 à 6 atomes de carbone, et de l'eau ;
où, dans l'étape de mélange, le composé de silicium ayant la formule $R_2{}^1Si(OR^2)_2$ est mélangé avec le rapport de 3 ou plus en moles par rapport à 2 moles de l'autre composé de silicium ayant la formule $Si(OR^2)_4$, et de l'eau est ajoutée avec une quantité substantiellement égale en poids à la quantité totale des deux composés de silicium ;
réalisation d'une hydrolyse dudit mélange pour qu'un sol organo silicique ayant un poids moléculaire de poids moyen de $10^3$ à $10^5$ soit formé par une polycondensation ;
dispersion du sol organo silicique dans un solvant organique hydrophilique pour former un liquide de sol organo silicique, où la quantité de solvant organique hydrophilique dans le sol organo silicique est au moins 80 % en poids ;
application du liquide de sol organo silicique sur le substrat du composant semi-conducteur ;
enlèvement du solvant organique ; et
application d'un traitement thermique au sol organo silicique pour former un oxyde de silicium solidifié.

**7.** Procédé selon la revendication 6, caractérisé en ce que
ledit autre composé de silicium ayant la formule $Si(OR^2)_4$ se compose de tétraméthoxysilane et ledit composé de silicium ayant la formule $R^1Si(OR^2)_2$ se compose de diméthyldiméthoxysilane.

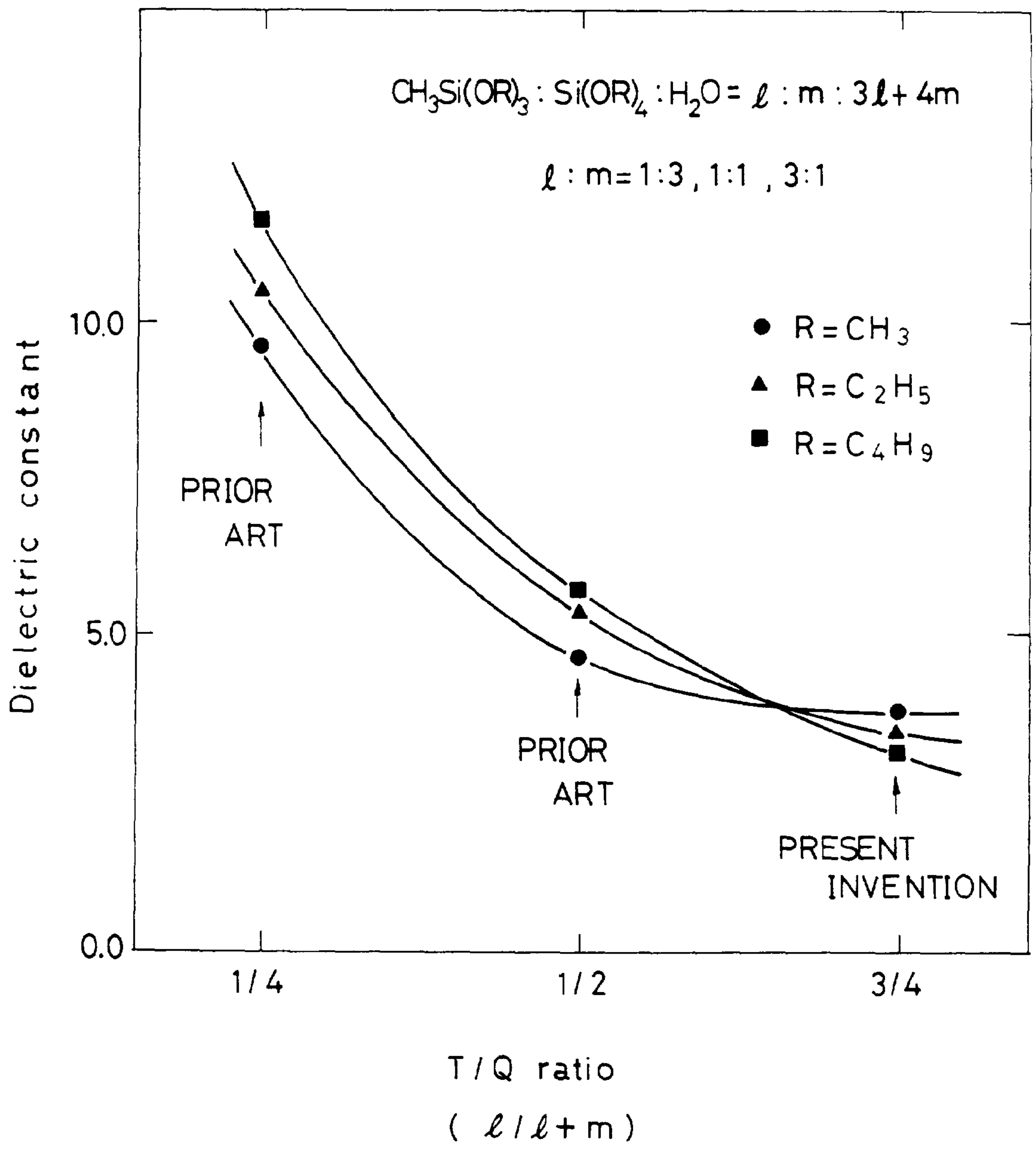
$CH_3Si(OR)_3 : Si(OR)_4 : H_2O = \ell : m : 3\ell + 4m$
$\ell : m = 1:3, 1:1, 3:1$
R = CH3
R = C2H5
R = C4H9
10.0
5.0
0.0
Dielectric constant
PRIOR ART
PRIOR ART
PRESENT INVENTION
1/4
1/2
3/4
T/Q ratio
( ℓ/ℓ+m )

FIG.1

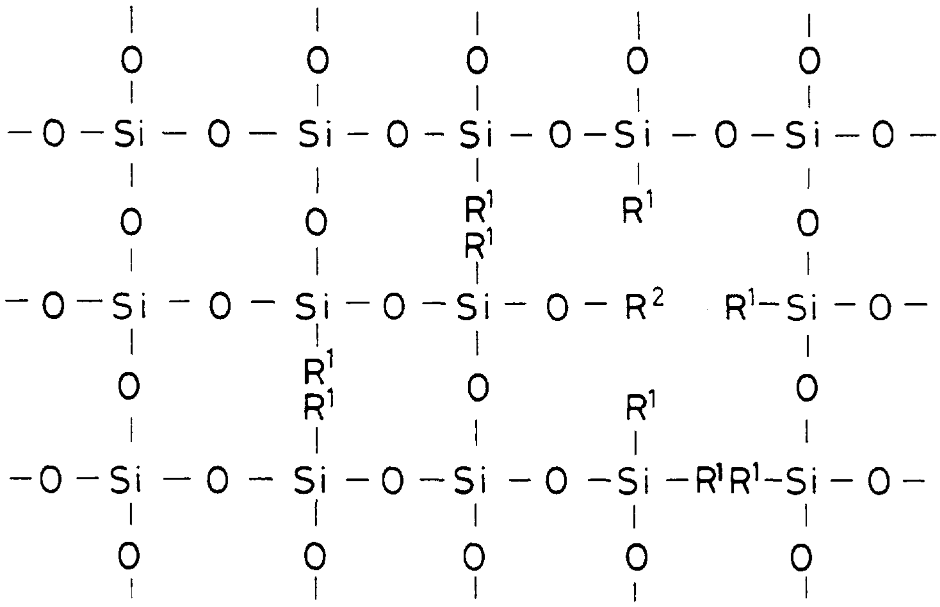

FIG. 2

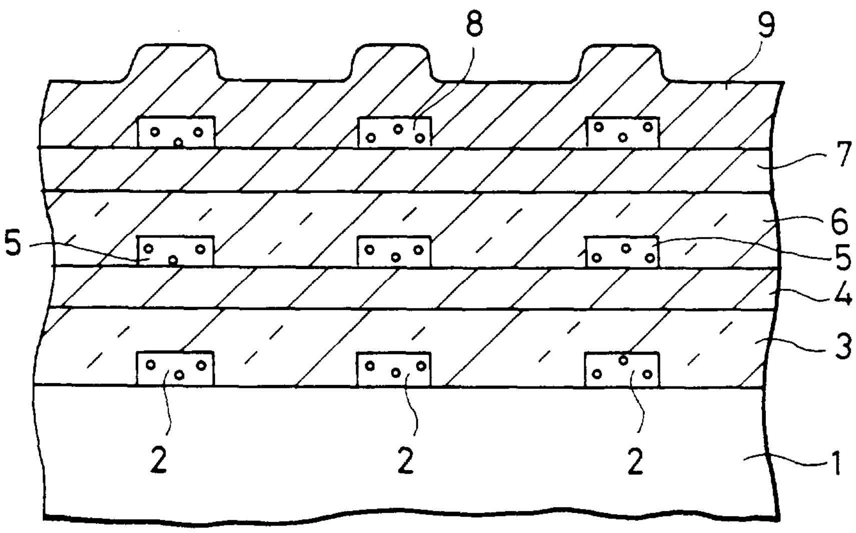


FIG. 3